(19) Europäisches Patentamt / European Patent Office / Office européen des brevets

(11) **EP 2 270 527 B1**

(12) **EUROPEAN PATENT SPECIFICATION**

(45) Date of publication and mention
of the grant of the patent:
**16.03.2016  Bulletin 2016/11**

(51) Int Cl.:
*G01R 31/36* *(2006.01)*     *H04W 24/06* *(2009.01)*

(21) Application number: **10184983.4**

(22) Date of filing: **29.07.2006**

(54) **System and method of determining standby time for mobile stations**

System und Verfahren zur Bestimmung der Standby-Zeit einer Mobilstation

Système et procédé de détermination du temps de veille d'une station mobile

(84) Designated Contracting States:
**AT BE BG CH CY CZ DE DK EE ES FI FR GB GR HU IE IS IT LI LT LU LV MC NL PL PT RO SE SI SK TR**

(30) Priority:  **29.07.2005  CA 2514164**

(43) Date of publication of application:
**05.01.2011  Bulletin 2011/01**

(62) Document number(s) of the earlier application(s) in accordance with Art. 76 EPC:
**06118146.7 / 1 748 663**

(73) Proprietor: **BlackBerry Limited
Waterloo, ON N2K 0A7 (CA)**

(72) Inventors:
• **Jin, Xin
Waterloo Ontario N2L 6R4 (CA)**
• **Mallalieu, Jennifer
Ottawa Ontario K2C 2L6 (CA)**
• **Shearer, Fiona
Ottawa Ontario K1Y 0G9 (CA)**

(74) Representative: **Gill Jennings & Every LLP
The Broadgate Tower
20 Primrose Street
London EC2A 2ES (GB)**

(56) References cited:
EP-A2- 0 803 959     WO-A-2005/024446
WO-A1-2004/003715   US-B1- 6 463 305

• **EDWARD BROREIN, AGILENT TECHNOLOGIES: "Using Battery Drain ANalysis to Improve Mobile-Device Operating Time", , [Online] 19 September 2002 (2002-09-19), XP002403452, USA Retrieved from the Internet: URL:www.agilent.com> [retrieved on 2006-10-16]**
• **"Battery Life Measurement Technique", GSM ASSOCIATION MOU PRD, [Online] no. TW.09, October 1998 (1998-10), XP002403451, Retrieved from the Internet: URL:http://www.gsmworld.com/documents/index.shtml> [retrieved on 2006-10-16]**
• **K. LAHIRI ET AL.: "Efficient Power Profiling for Battery-Driven Embedded System Design", IEEE TRANS. ON COMPUTER-AIDED DESIGN OF INTEGRATED CIRCUITS AND SYSTEMS, [Online] vol. 23, no. 6, June 2004 (2004-06), XP002403453, Retrieved from the Internet: URL:http://ieeexplore.ieee.org/iel5/43/28935/01302191.pdf> [retrieved on 2006-10-16]**

**Description**

This patent document relates generally to testing mobile stations, and in particular to a system and method of determining standby time for mobile stations.

Mobile station battery life is usually described in terms of talk-time and standby time. Known methods of measuring standby time for mobile stations require substantial lengths of time to execute. With the proliferation of mobile station models and features, standby time determination must be repeated for each new variation, adding considerable cost to test protocols. The current method used to test standby time detailed in a standard by the CDMA Development Group (CDG 35) has an extremely long test time which is equal to its standby time, almost 10 days in some cases. The length of these tests makes it nearly impracticable to run multiple test cases.

The state of battery life measurement in 2002 is reviewed in "Using Battery Drain Analysis to Improve Mobile Device Operating Time" by Edward Brorein, Agilent Technologies Here it is recognised that test times for battery usage of a mobile device can be reduced by determining battery life from average current drain measured for a period deemed to be representative of the overall operating time.

There is a need for a mobile terminal standby test method and apparatus that reduces test times.

In accordance with an aspect of the patent disclosure, there is provided a method of determining standby time for a mobile station according to claim 1.

In accordance with another aspect of the patent disclosure, there is provided a system configured to determine standby time for a mobile station according to claim 13.

In accordance with another aspect of the patent disclosure, there is provided a computer-readable medium configured with code to determine standby time for a mobile station according to claim 23.

BRIEF DESCRIPTION OF THE DRAWINGS

An embodiment of the patent disclosure will now be described by way of example only with reference to the following drawings in which:

Fig. 1 there is illustrated an example of a system for determining standby time, in accordance with an embodiment of the patent disclosure;

Fig. 2 there is illustrated an example of a four wire setup for a mobile station under test (MSUT) in accordance with an embodiment of the patent disclosure;

Fig. 3 graphically illustrates an example of transmit mode current measurement, in accordance with an embodiment of the system for determining standby time of the MSUT;

Fig. 4 graphically illustrates an example of receive mode current measurement in accordance with an embodiment of the system for determining standby time of the MSUT;

Fig. 5 shows in a flowchart an example of a method of determining standby time for mobile stations, in accordance with an embodiment of the patent disclosure;

Fig. 6 shows in a flowchart another example of a method of determining standby time for mobile stations, in accordance with an embodiment of the patent disclosure;

Fig. 7 shows in a flowchart another example of a method of determining standby time for mobile stations, in accordance with an embodiment of the patent disclosure;

Fig. 8 shows in an execution and variable flow diagram another example of a method of determining standby time for mobile stations, in accordance with an embodiment of the patent disclosure;

Fig. 9 shows in a flowchart an example of a method of determining the radio shut off voltage, in accordance with an embodiment of the patent disclosure;

Fig. 10 shows in a flowchart another example of the process to determine radio shut off voltage, in accordance with an embodiment of the patent disclosure;

Fig. 11 shows in a flowchart an example of a method of characterizing transmit current measurements, in accordance with an embodiment of the patent disclosure;

Fig. 12 shows in a flowchart another example of a method of characterizing transmit current measurements, in accordance with an embodiment of the patent disclosure;

Fig. 13 shows in a flowchart an example of a method of characterizing receive current measurements, in accordance with an embodiment of the patent disclosure; and

Fig. 14 shows in a flowchart another example of a method of characterizing receive current measurements, in accordance with an embodiment of the patent disclosure.

DESCRIPTION OF PREFERRED EMBODIMENTS

The patent disclosure preferably describes a solution to one or more of the problems described above.

The technology disclosed herein is preferably suited for use in Personal Digital Assistants (PDAs), mobile communication devices, cellular phones, and wireless two-way e-mail communication devices (collectively referred to herein as "mobile stations" or "mobile devices").

The term "battery capacity" is used to refer to the capacity of a battery. Typically in a mobile terminal environment it is the amount of discharge from a fully charged battery, to the mobile terminal battery cut off voltage. The battery cut off voltage is usually the voltage at which the mobile terminal shuts down or in some instance where the radio is shut off or disabled. The term "battery capacity consumed" (also known as "charge consumed" or "charge") is used to refer to the amount of discharge.

A system and method of the patent disclosure will now be described with reference to various examples of how the invention can best be made and used. For convenience, like reference numerals are used throughout the description and several views of the drawings to indicate like or corresponding parts, wherein the various elements are not necessarily drawn to scale. All units of measurement provided in this disclosure are by way of example only. Alternative units of measurement can be used with appropriate amendments to the calculations described herein.

This method simulates the standby time of the MSUT. The following method describes the calculations that were used to achieve the results.

Capacity, measured in units of Ampere*hours (Ah), is a standard indication of how long a battery can last. The standby time (hours) of a MSUT can be calculated by dividing the capacity available from a fully charged battery by the capacity used in one hour (i.e., the amount of charge discharged in one hour) with the MSUT in standby.

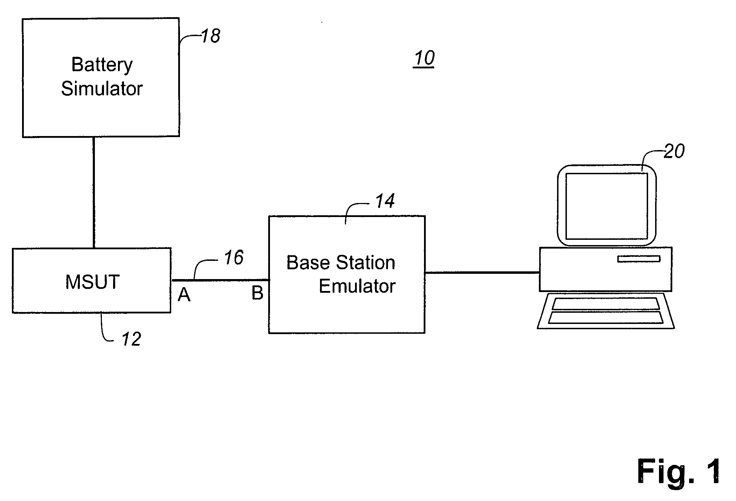

Referring to Fig. 1 there is illustrated a system 10 for determining standby time for a mobile station. Test equipment coupled to a MSUT 12 (with its battery removed) includes a base station emulator 14, for example an Agilent 8960-10 coupled via a radio frequency (RF) cable 16 to the MSUT antenna connector, a battery simulator (also known as a "battery simulator power supply", referred to as a battery simulator in this description) 18 coupled to the battery contacts of the MSUT 12, for example an Agilent 66321D, an equivalent series resistance (ESR) is programmed in the battery simulator 18 to equate to the ESR value of the battery used in the MSUT may be used (alternatively a lead having the same series resistance as the ESR of the mobile battery may be used) and a computer 20 for data collection and/or control.

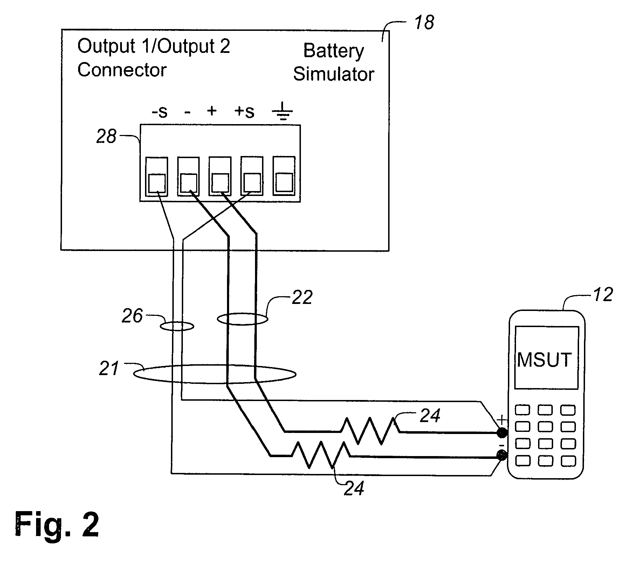

Referring to Fig. 2 there is shown a four wire setup 21 between the battery simulator 18 and the MSUT 12. The wire set up includes a pair of power lines twisted together 22, each having (undesirable) series resistance of the wire 24, and a twister pair of sense lines 26. The mobile battery is removed and the battery simulator 18 is connected using the four wire set up 21 so that the battery simulator 18 would effectively compensate for the series resistance 24. If the four wire set up 21 is not used then the external equivalent series resistance (ESR) 24 of the wires connecting to the battery simulator to the device must be accounted for in programming the battery ESR value into the battery simulator 18.

The mobile station RF insertion loss between the MSUT 12 and the wireless device tester (i.e. RF cable AB 16) is measured over a range of frequencies using a network analyzer (not shown). The insertion losses are then used in this test to correct the settings for the base station emulator 14 transmit power.

For any given battery voltage, the remaining battery capacity or charge can be determined from tables provided by the battery manufacturer as a function of unloaded voltage of the battery. (The tables can also be determined by discharging a battery with a constant known load while measuring the voltage as a variable over time.) From the tables, the capacity or charge remaining in a fully charged battery ($C_{new}$) and a discharged battery ($C_{cutoff}$) can be determined. The difference is the total battery capacity or charge available to the MSUT.

The voltage of a fully charged battery is dependent on the charger in the MSUT and also on the battery. It can be obtained by measuring the battery voltage using a voltage meter after a battery is fully charged by the charger within the MSUT. However, a cut off voltage (i.e., the voltage at which to turn off the radio by the MSUT) is determined for each individual test case by stepping down the voltage until the radio turns off. Depending on the MSUT software/hardware implementation, it may be necessary to increase the wait time between the voltage steps to ensure that the MSUT has time to update. For simplifying a test, approximations may also be made by only testing one or a few representative test conditions for the cut-off voltage, e.g., using the maximum transmit power condition in a traffic channel transmitting state, rather than testing for each individual conditions such as idle state, registration state, traffic channel transmitting state, etc. Although traffic transmitting state is not used in usual stand-by conditions, since it is easy to configure and simplifies the test, it can be used to simulate the registration condition with certain degree of accuracy. (Traffic channel and max Tx power condition can be used as a way of approximation).

There are two modes in standby: Receive and Transmit. For the most part the MSUT 12 is in Receive mode, where it waits to receive messages from the network. In this mode, the current draw is quite small. The device spends most of the time in sleep mode, and wakes up for short period of time at scheduled time slots to receive messages from base stations. In Transmit mode, the MSUT is required to transmit registration probes at regular intervals as specified by the network. This mode occurs less frequently, but draws significantly more current when in that state.

In either mode, the capacity or charge used by the MSUT 12 can be determined by measuring the current. Capacity or charge consumed is the integral of current with respect to time: $C = \int i(t)\, dt$. This can be quantized into: $C = \Sigma\, i(t) * \Delta t$. Therefore, the capacity or charge ( C ) can be determined by summing the products of current ( i(t) ) and time interval ( $\Delta t$ ) of current measurement over small intervals, i.e., taking the sum of these measured currents and multiplying the sum by the time interval ( $\Delta t$ ). The capacity or charge used by the MSUT 12 in Receive and Transmit modes is dealt with separately.

In Transmit mode, current measurements are taken for multiple transmit events to determine the total average capacity or charge used for transmitting. For the $j^{th}$ transmit event, the capacity or charge used for transmitting is $C_j$. The total time spent transmitting during that transmit event, $t_j$, is also calculated, as it is needed for calculations later on. The battery current for each transmit event is taken from the MSUT 12 as a vector of equally spaced sample data points. The sampling interval is, in one example, 4ms and a total of 4096 current measurement data points are downloaded from the battery simulator 18 for each event which form the vector. The actual transmit portion is extracted from the vector.

In a live network, the MSUT 12 may be configured for timer-based registration to transmit at intervals of 15 minutes, 30 minutes, or even longer. By using the test procedure described above in the Base Station Emulator 14 this interval can be configured to be shorter to reduce the amount of test time required to achieve a statistically significant data set of transmit events.

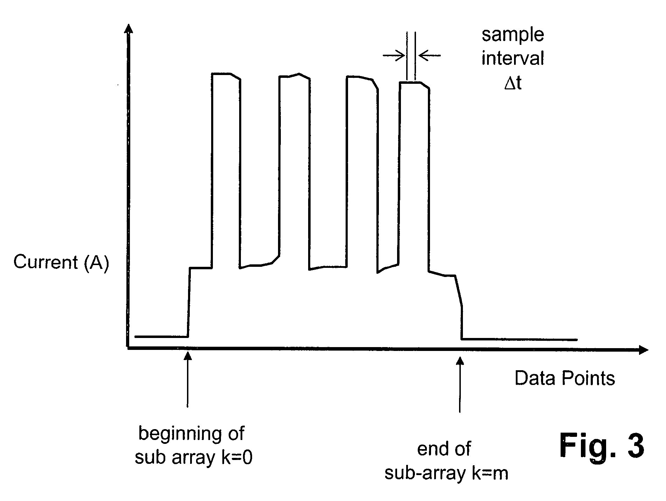

Fig. 3 illustrates an example of a current measurement during Transmit mode, where k represents the data points in the current measurement vector and where $\Delta t$ represents the sample interval between data points in the vector. The element corresponding to k=0 is the first element of the extracted sub-array for the transmit activity, and k=m the last. The beginning and the end of the sub-array is determined by finding the first and the last elements of the measured current array that has higher current value than receive current of the MSUT during "wake-up" of slotted mode operation.

The equations for the capacity or charge $C_j$ and time $t_j$ for each transmit event are shown here, where the current of the $k^{th}$ point in the measurement vector is called $i_k$:

$$C_j = \left( \sum\nolimits_{k=0}^{m} \; (\, i_k \,) \right) * \Delta t;$$

and

$$t_j = m * \Delta t.$$

Using the total number of transmit events measured (N) and the number of times the MSUT registers per hour (M) in a network (where in the network, M may or may not be an integer), the total average capacity or charge used for transmitting in one hour ($C_{tx\_in\_1hr}$) and the total average time spent in one hour for transmitting ($t_{tx\_in\_1hr}$) can be determined:

$$C_{tx\_in\_1hr} = \left( \sum\nolimits_{j=1}^{N} \; (C_j) \right) * (M / N);$$

and

$$t_{tx\_in\_1hr} = \left( \sum\nolimits_{j=1}^{N} \; (t_j) \right) * (M / N).$$

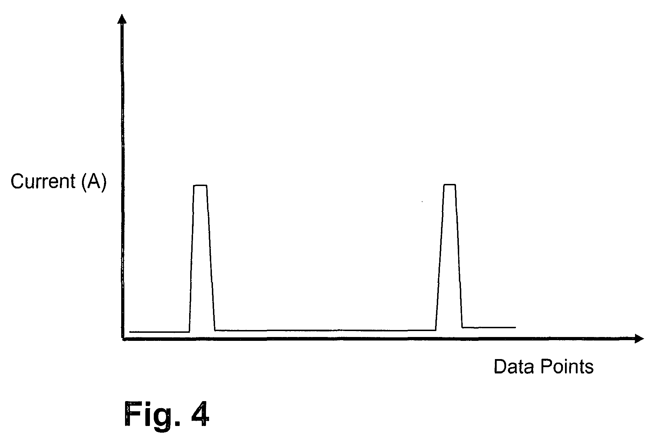

Referring to Fig. 4, illustrated is an example of a Receive Mode Current Measurement. In Receive mode (including sleep state, processor wake-up activities, and receiver wake-ups in slotted mode), the current waveform has a series of peaks that corresponds to intervals of MSUT 12 activity. The peaks of current caused by wakeups appear at known regular intervals, whereas the peaks caused by processor wake-ups can appear at variable intervals. Each receive measurement is set to capture the current for all receive states including the peaks and base levels, and takes the average current $i_{rx}$. In one example, the measurement interval is 1ms, a total of 4096 values are in each measured vector.

Since the time spent in Receive mode is simply the amount of time not spent in transmitting, using hour as the unit for time, the total capacity or charge used by the MSUT during one hour while in Receive mode can be found by:

$$C_{rx\_in\_1hr} = (i_{rx} * (1 - t_{tx\_in\_1hr})).$$

Alternatively, since the time spent in transmitting access probes for timer based registration is much smaller than the time spent in Receive mode, the $t_{tx\_in\_1hr}$ can be treated approximately as 0 in the calculation of Receive mode consumed capacity or charge.

Therefore the total capacity or charge used by the MSUT in one hour is the sum of the capacity used in both the Receive and Transmit modes:

$$C_{1hr} = C_{rx\_in\_1hr} + C_{tx\_in\_1hr}.$$

The tests may be conducted at different supply voltages and make an average if $C_{1hr}$ is dependent of voltage for improved accuracy.

After determining the available battery capacity, ($C_{new}$ - $C_{cutoff}$), and the total capacity or charge used by the MSUT in one hour, $C_{1hr}$, the Standby Time ($T_{standby}$ measured in days) can be determined by:

$$T_{standby} = (C_{new} - C_{cutoff}) / (C_{1hr} * 24 \text{ hrs/day}).$$

This test method significantly reduces the time required to complete the standby time test cases. Each test can be completed in a matter of hours, instead of days or even weeks.

Alternatively, stand-by time can be calculated using average current instead of consumed capacity (or charge) per hour. In fact, since the quantity current is defined as charge per unit time, charge per hour is also in a dimension of current. Therefore, the only difference is the unit: Amperes (i.e., Coulombs/sec) for the former, and Coulombs/3600sec for the latter. The terms capacity used in a given time duration, charge consumed in a given time duration, and current consumption are used interchangeably in this disclosure.

The alternative formula for using average current to compute the average transmit capacity or charge consumed by a registration event is:

$$C_{tx} = 1/N \sum_{j=1}^{N} (C_j).$$

The alternative formula for using average current to compute the average transmit current is:

$$i_{tx} = C_{tx} / T_{tx},$$

where $T_{tx}$ is registration interval.

The alternative formula for using average current to compute the average receive current is:

$$i_{rx} = 1/T \sum_{t=0}^{T}$$

i(t) * Δt, where T is the current measurement interval.

The alternative formula for using average current to compute the stand-by time is:

$$T_{standby} = (C_{new} - C_{cutoff}) / (i_{tx} + i_{rx}).$$

Standby time is the length of time the mobile station under test (MSUT) 12 can operate in standby mode using its internal battery power.

One embodiment of the test setup is provided herein below for CDMA mobile terminals.

Set the Base Station Emulator according to the test specification. The following shows one example:

• Access parameters:

- Nominal Power: 0
- Nominal Power Extended: 0
- Initial Power: 0
- Power Step: 3
- Number of Steps: 5
- Max Response Sequence: 2
- Max Request Sequence: 2
- Preamble Size: 3

- RSSI = -75 dBm and Pilot Ec/Io = -7 dBm
- The Base Station Emulator also has the following default settings:

  ◦ SEARCH WIN_A = 8
  ◦ SEARCH WIN_N = 8
  ◦ SEARCH WIN_R = 8
  ◦ Neighbor list includes 7 PN's

- The Slot Cycle Index in the MSUT can be set to 2 and the Max Slot Cycle Index in the base station emulator is set to either 1 or 2 or other values depending on the test case.
- If the test case requires QPCH be set to ON, then the QPCH level is set to -3 dB relative to pilot.
- Configuration Change Indicator (CC1) is Off

Deactivate any radio activities other than idle mode operation, and deactivate any unnecessary applications.

For each Band Class in which the MSUT operates, test the following scenarios using the above specified settings:

- Timer Based Registration Period = 15 minutes, QPCH ON (SCI=1 & SCI=2)
- Timer Based Registration Period = 15 minutes, QPCH OFF (SCI=1 & SCI=2)
- Timer Based Registration Period = 30 minutes, QPCH ON (SCI=1 & SCI=2)
- Timer Based Registration Period = 30 minutes, QPCH OFF (SCI=1 & SCI=2)

A test procedure was developed to calculate the standby time based on radio shut-off voltage measurements, the total battery capacity between the fully charged battery voltage and the measured radio shut-off voltage, and multiple current measurements during receive and transmit. The time taken to run a standby time test using this method is considerably shorter than measuring the actual standby time of the device with a battery.

The standby time test procedure comprises four major parts:

1) Determining the battery voltage at which the radio turns off and determine available capacity of the battery;
2) Characterizing transmit current measurements (CDMA registration);
3) Characterizing receive current measurements; and
4) Calculating the standby time of the MSUT.

Setup equipment and MSUT as shown in Figs. 1 and 2 and wait for the MSUT to go into idle mode.

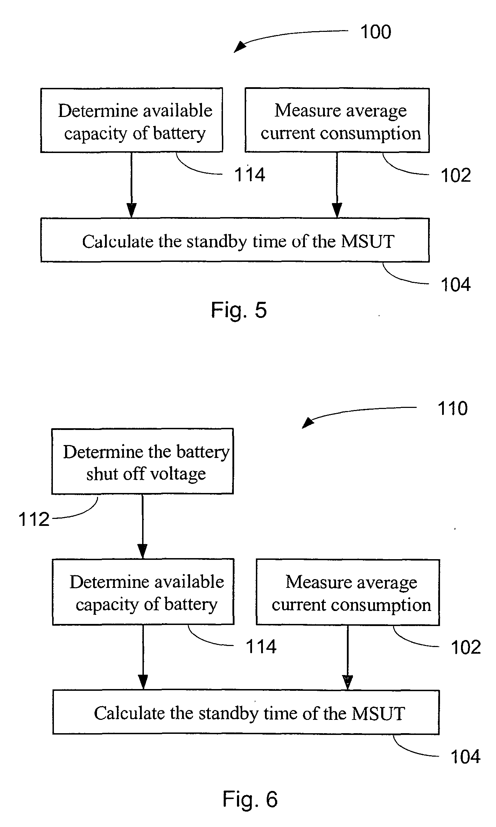

Fig. 5 shows in a flowchart an example of a method of determining standby time for mobile stations (100), in accordance with an embodiment of the patent disclosure. The method (100) comprises the steps of measuring average current consumption (102) and determining the available battery capacity (114). Next, the standby time of the MSUT is calculated (104) based upon the available battery capacity and measured average current consumption. Other steps may be added to the method (100).

Fig. 6 shows in a flowchart another example of a method of determining standby time for mobile stations (110), in accordance with an embodiment of the patent disclosure. The method (110) comprises the steps of determining the battery voltage at which the radio turns off (112) and determining the available capacity of the battery (114). Next the average current consumption is measured (102) and the standby time of the MSUT is calculated (104). Other steps may be added to the method (100).

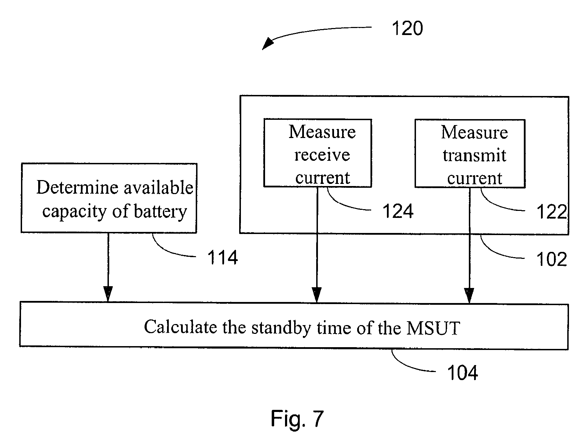

Fig. 7 shows in a flowchart another example of a method of determining standby time for mobile stations (120), in accordance with an embodiment of the patent disclosure. The method (120) comprises the steps of determining the available capacity of the battery (114), measuring transmit current (CDMA registration) (122) and measuring receive transmit current (124). Next the standby time of the MSUT is calculated (104). Other steps may be added to the method (100).

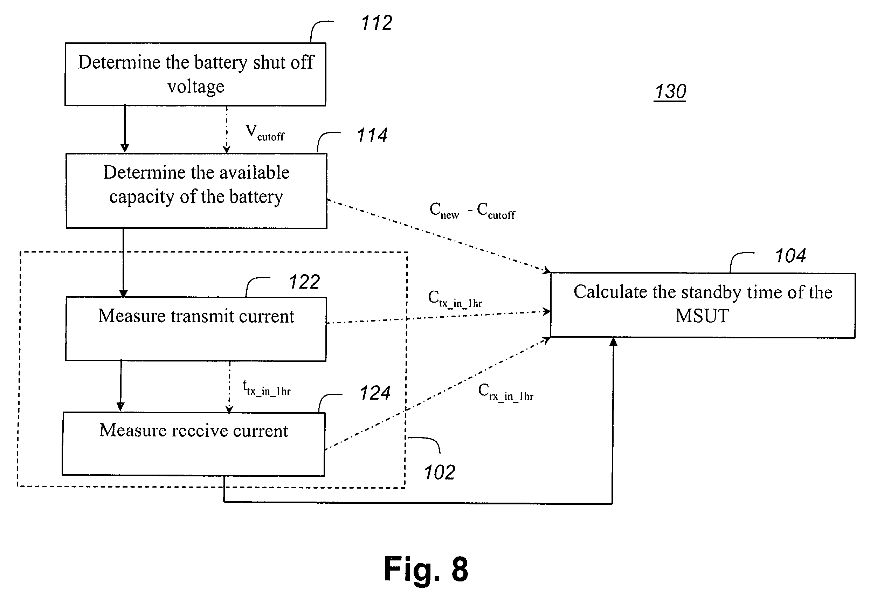

Fig. 8 shows in an execution and variable flow diagram another example of a method of determining standby time for mobile stations (130), in accordance with an embodiment of the patent disclosure. The method (130) comprises the steps of determining the battery voltage at which the radio turns off ($V_{cutoff}$) (112) and determining the available capacity of the battery (114). Next, transmit current is measured (CDMA registration) (122). Next, receive current is measured (124). The transmit current time measurement $t_{tx\_in\_1hr}$ was calculated in step (122). Finally, the standby time of the MSUT is calculated (104). For the last step (104), the available capacity $C_{new} - C_{cutoff}$ was calculated in step (114), the transmit current capacity measurement $C_{tx\_in\_1hr}$ was calculated in step (122) and the receive current measurement $C_{rx\_in\_1hr}$ was calculated in step (124). Alternatively, if the available capacity and/or the transmit current capacity measurements are known, these may be provided to a module that executes the final step (104).

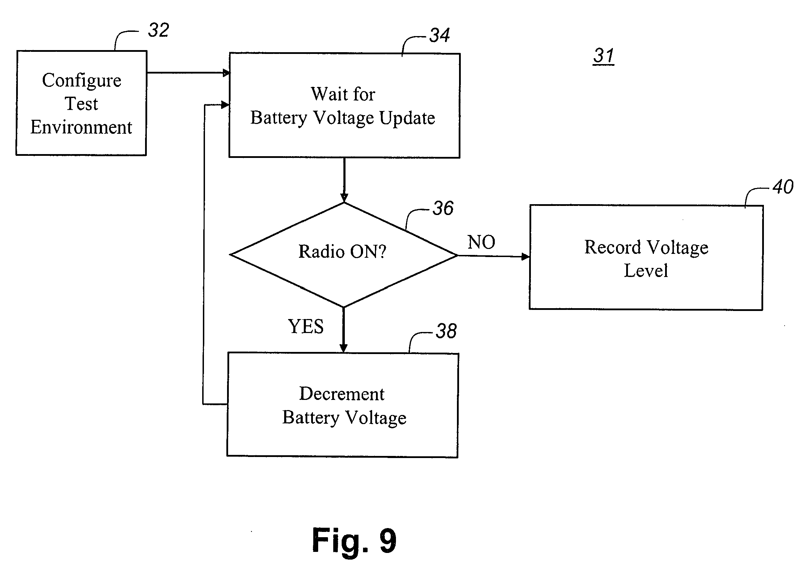

Fig. 9 shows in a flowchart an example of a method of determining the radio shut off voltage (31), in accordance with an embodiment of the patent disclosure. The method (31) begins with configuring a test environment by setting up a mobile to be set to desired working conditions (32). Next, wait the sufficient time needed for the MSUT software/hardware to update the battery voltage internally (34). If the ratio is still on (36), then decrement the battery voltage (38) and return to step (34). Otherwise (36), record the voltage level at which the radio turned off (40). Other steps may be added to this method (31).

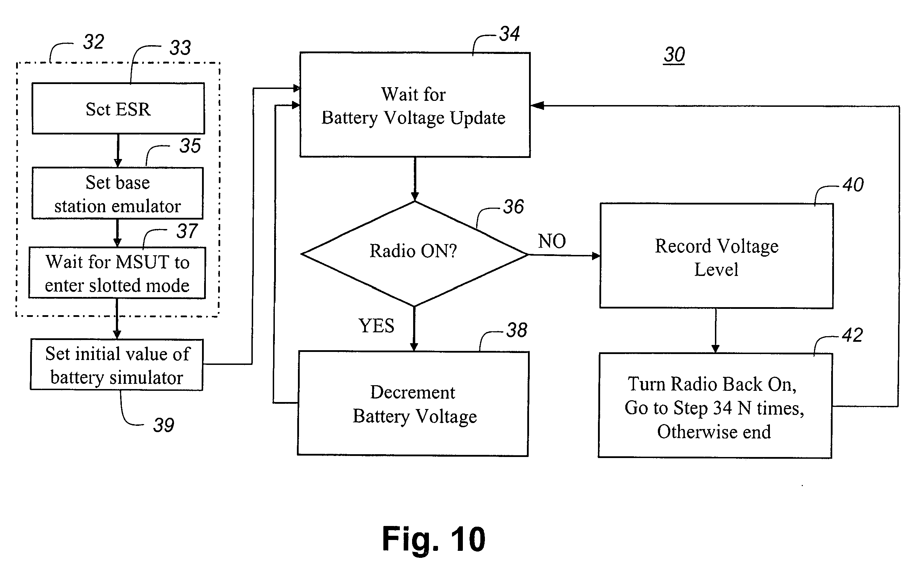

Fig. 10 shows in a flow chart another example of the process to determine radio shut off voltage (30), in accordance with an embodiment of the patent disclosure. The process (30) comprises generally of the following steps:

1) Program the battery simulator to simulate the ESR of the battery using 4-wire setup (33).
2) Set the base station emulator to transmit at desired level in accordance to test specification, and set all other parameters in accordance to test specification (35).
3) Wait for the MSUT to acquire the signal from the base station emulator, and enter the slotted mode of operation (37).
4) Program the battery simulator unloaded voltage to a small quantity (for example, 0.2 V) above the expected radio shut-off voltage, to initiate test (39).
5) Wait sufficient time needed for the MSUT software/hardware to update the battery voltage internally (34).
6) Query to see if the radio is still on (36). (This can be accomplished by trying to force a registration of the MSUT with the base station emulator).
7) Step the battery voltage down by a small quantity (for example, 0.01V) (38).
8) Repeat steps 5 thru 7 until radio turns off.
9) Record the voltage level at which radio turns off (40).
10) Program the battery simulator unloaded voltage to a small quantity (for example, 0.2 V) above the expected radio shut-off voltage, turn the radio back on, and repeat steps 5 thru 9 a number of times to get a reliable average value of radio shut-off voltage (42).

Once the radio off voltage has been determined, the available capacity of the battery to be used in the standby time calculations is calculated. To do this, the battery capacity vs. unloaded voltage profile table is characterized.

To characterize the transmit current measurements (122), the base station emulator is set with the timer based registration to "on" and the base station emulator is programmed to have the MSUT 12 register periodically (preferably shorter than the actual registration interval when used in a CDMA network, for example, every 12.1 to 30 seconds), disabling all other types of registrations except power up registration, and set the base station emulator output power to the values as defined in the test specification (e.g., - 75 dBm) with path loss accounted for. The setting to have MSUT 12 register every 12.1 to 30 seconds is not related to the network configuration under which the standby time to be tested and is used only to reduce test time.

Using the battery simulator 18, the output voltage is set to a desired value, e.g., the nominal battery voltage, and a sampling interval and array size are selected which will have a long enough window to be able to extract the sub-array of the measured battery current to cover the entire transmit activity from start of the transmitter warm-up for the registration to its end (e.g., download 4096 data points from battery simulator 66321D at sampling interval of 4 ms will ensure a window large enough to capture transmit and back to receive). The battery simulator can buffer pre-trigger current measurement data points, which will ensure capturing current data prior to the triggering point and covers a time span from receive to transmit back to receive modes. See Figure 3 as an example.

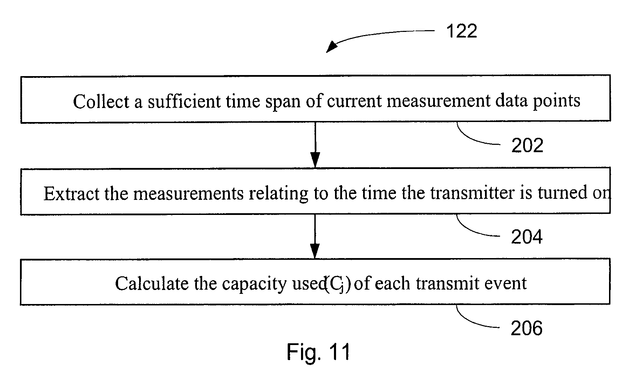

Fig. 11 shows in a flowchart an example of a method of measuring transmit current (122), in accordance with an embodiment of the patent disclosure. The method (122) comprises the steps of collecting a sufficient time span of current measurement data points (202). Next, the measurements relating to the time the transmitter is turned on are extracted (204). Finally, the capacity used ($C_j$) and time duration ($t_j$) of each transmit event are calculated (206). Other steps may be added to this method (122).

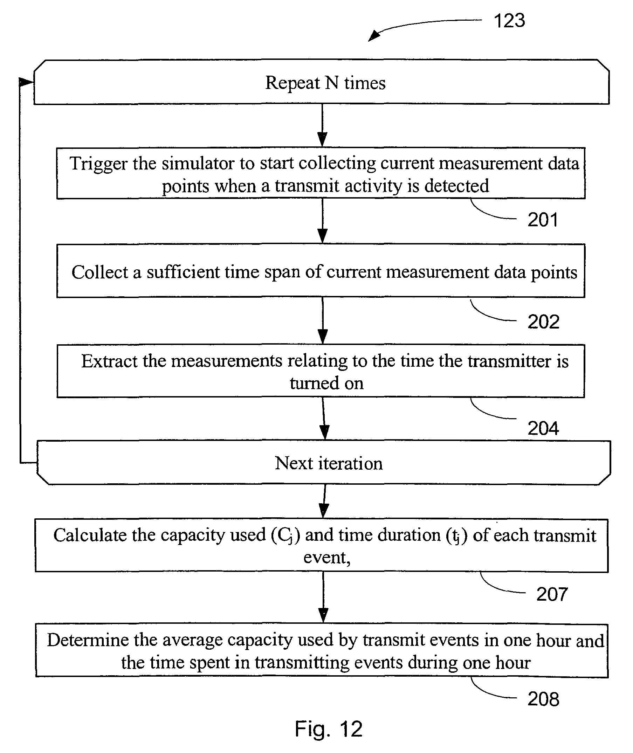

Fig. 12 shows in a flowchart another example of a method of measuring transmit current (123) using the battery simulator 18, in accordance with an embodiment of the patent disclosure. The method (123) comprises generally of the following steps:

1) Trigger the simulator to start collecting current measurement data points when a transmit activity is detected (201) (e.g., by a threshold set for current level exceeding the current consumption level for receiver only operation, such as 250 mA).

2) Collect the sufficient time span of current measurement data points from battery simulator (202) (66321D will be able to download an array of 4096 data points).

3) Extract, from the data array, the sub-array for the portion of time the transmitter is turned on (204).

4) Knowing the current at each data point in the sub-array extracted, allows the calculation of the capacity used ($C_j$) and time duration ($t_j$) of each transmit event (206):

$$C_j = \left( \sum\nolimits_{k=0}^{m} (i_k) \right) * \Delta t;$$

and

$$t_j = m * \Delta t,$$

where k=0 is the first point of the transmit activity, m is the last point of the transmit activity, and $\Delta t$ is the sample interval.

5) Repeat 1) through 5) to record N transmit measurements (desirably N > 100).

6) Determine the average capacity used by transmit events in one hour ($C_{tx\_in\_1hr}$), and the time spent in transmitting events during one hour ($t_{tx\_in\_1hr}$) (208).

$$C_{tx\_in\_1hr} = \left( \sum\nolimits_{j=1}^{N} (C_j) \right) * (M / N);$$

and

$$t_{tx\_in\_1hr} = \left( \sum\nolimits_{j=1}^{N} (t_j) \right) * (M / N),$$

where N is the total number of transmit events measured; and where M is the number of registrations per hour based on network registration period configuration for which the standby time needs to be determined (M may not be an integer).

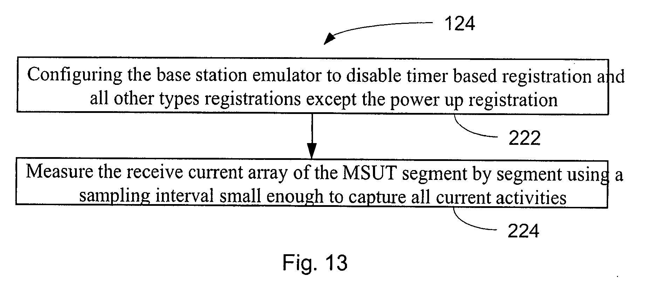

Fig. 13 shows in a flowchart an example of a method of measuring receive current (124), in accordance with an embodiment of the patent disclosure. The method (124) begins with configuring the base station emulator to disable timer based registration and all other types registrations except the power up registration (222). Next, the receive current array of the MSUT is measured segment by segment using a sampling interval small enough to capture all current activities (224). Preferably, this sampling interval is no larger than 1ms. Other steps may be added to this method (124).

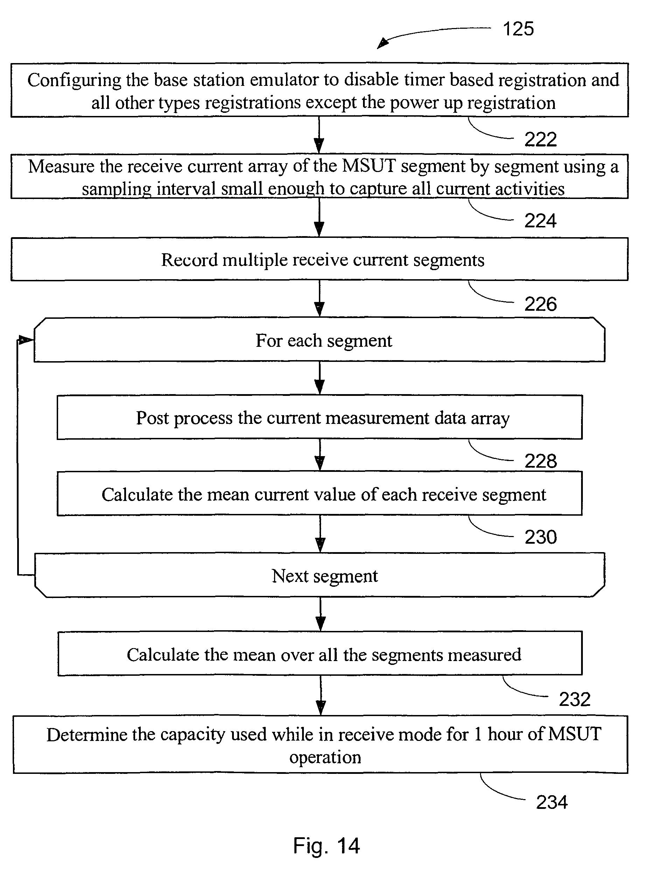

Figure 14 shows in a flowchart another example of a method of measuring receive current (125), in accordance with an embodiment of the patent disclosure. The following receive current measurements are performed for each test condition being tested (such as SCI values, quick paging settings). Again, using the battery simulator,

1) Configure the base station emulator to disable timer based registration and all other types registrations except the power up registration (222).

2) Measure the receive current array of MSUT segment by segment using a sampling interval small enough to capture all current activities (224). Preferably, this sampling interval is no larger than 1 ms.

3) Record multiple receive current segments (226) (e.g., greater than 100).

4) For each segment, post process the current measurement data array (228), calculate the mean current value of each receive segment (230), and further calculate the mean over all the segments measured (232), denote it $i_{rx}$.

5) Determine the capacity used while in receive mode for 1 hour of MSUT operation (234):

In 1 hour operation, the amount of time spent in receive mode is simply the amount of time the MSUT is not in transmit mode, which is $(1 - t_{tx\_in\_1hr})$ hour, thus the capacity used for 1 hour by receive mode:

$$C_{rx\_in\_1hr} = (i_{rx} * (1 - t_{tx\_in\_1hr})).$$

The capacity used in one hour for both transmit and receive activities is known, thus the total capacity used by the MSUT in one hour is:

$$C_{1hr} = C_{rx\_in\_1hr} + C_{tx\_in\_1hr}.$$

Using the available battery capacity determined as described previously, the standby time in hours can then be determined (104) by:

$$T_{standby} = (C_{new} - C_{cutoff}) / (C_{1hr}).$$

The system and methods according to the present disclosure may be implemented by any hardware, software or a combination of hardware and software having the above described functions. The software code, either in its entirety or a part thereof, may be stored in a computer readable memory. Further, a computer data signal representing the software code which may be embedded in a carrier wave may be transmitted via a communication network. Such a computer readable memory and a computer data signal are also within the scope of the present disclosure, as well as the hardware, software and the combination thereof.

While particular examples of the patent disclosure have been shown and described, changes and modifications may be made to such examples without departing from the true scope of the patent disclosure as defined by the appended claims.

## Claims

1. A method of determining standby time for a mobile station (12), the method comprising:

   generating a simulated battery voltage for the mobile station;
   measuring current consumption (102) of the mobile station (12) in a standby mode using the simulated battery voltage, wherein the measuring includes measuring current activities as the mobile station (12) periodically activates its receiver to monitor for a communication signal;
   determining an available battery capacity (114) of a battery for the mobile station; and
   determining a standby time (104) for the mobile station based on the current consumption and the available battery capacity,
   wherein the measuring of the current consumption is performed for a time period less than the standby time of the mobile station.

2. The method of Claim 1 wherein the generating the simulated battery voltage is performed by a battery simulator (18).

3. The method of Claim 2 further comprising:

   programming the battery simulator (18) with an equivalent series resistance (24) equal to the equivalent series resistance of the battery, wherein the equivalent series resistance is used in generating the simulated battery voltage.

4. The method of any preceding claim wherein the current consumption measured is an average value determined over the time period.

5. The method of any preceding claim wherein the time period is one hour.

6. The method of any preceding claim wherein the standby mode includes a transmit mode and a receive mode.

7. The method of claim 6, wherein the current consumption is measured in both the transmit mode and the receive mode.

8. The method of claim 7, wherein the mobile station (12) periodically activating its receiver to monitor for a communication signal occurs in the receive mode.

9. The method of any preceding claim further comprising:

    determining a radio off battery voltage (40) for the mobile station based on the simulated battery voltage.

10. The method of Claim 9 wherein the radio off battery voltage (40) for the mobile station is determined by stepping down the simulated battery voltage until the radio of the mobile station turns off.

11. The method of claim 9 or claim 10, wherein determining a radio off battery voltage (40) comprises:

    providing a simulated battery voltage at a first voltage value (39) to the mobile station;
    determining if a mobile station radio is on (36);
    if the mobile station radio is on, decrementing the first voltage value (38) to a next voltage value by a predetermined amount, and repeating the determining if a mobile station radio is on (36); and
    if the mobile station radio is off, recording the voltage value as the radio off battery voltage.

12. The method of any of Claims 9 to 11 further comprising:

    fully-charging the battery; and
    determining the fully-charged voltage of the battery after being fully charged, and
    wherein the available battery capacity is determined based on a difference between the fully-charged voltage and the radio off battery voltage (40).

13. A system (10) configured to determine standby time for a mobile station (12), the system comprising:

    a battery simulator (18) configured for connection to the mobile station (12), the battery simulator (18) configured to generate a simulated battery voltage to power the mobile station (12); and
    a computer (20) configured to
    measure current consumption (102) of the mobile station (12) in a standby mode, while current consumption is measured, the mobile station (12) periodically activating its receiver to monitor for a communication signal,
    determine an available battery capacity (114) of a battery for the mobile station, and
    determine a standby time (104) for the mobile station based on the current consumption and the available battery capacity, wherein the measuring of the current consumption is performed for a time period less than the standby time of the mobile station.

14. The system (10) of Claim 13 further comprising:

    a base station emulator (14) configured to communicate with the mobile station (12) to cause the mobile station (12) to enter the standby mode.

15. The system (10) of Claim 13 or Claim 14 wherein the computer (20) is configured to measure the current consumption as an average value determined over the time period.

16. The system (10) of any of Claims 13 to 15 wherein the time period is one hour.

17. The system (10) of any of Claims 13 to 16 wherein the standby mode includes a transmit mode and a receive mode.

18. The system (10) of Claim 17, wherein the current consumption is measured in both the transmit mode and the receive mode.

19. The system (10) of Claim 18, wherein the mobile station (12) periodically activating its receiver to monitor for a communication signal occurs in the receive mode.

20. The system (10) of any of Claims 13 to 19 wherein the battery simulator (18), computer (20) and base station emulator (14) are configured to determine a radio off battery voltage (40) by:

    providing a simulated battery voltage at a first voltage value to the mobile station;
    determining if a mobile station radio is on;
    if the mobile station radio is on, decrementing the first voltage value to a next voltage value by a predetermined amount, and repeating the determining if a mobile station radio is on; and
if the mobile station radio is off, recording the voltage value as the radio off battery voltage.

21. The system (10) of any of Claims 13 to 20 wherein a charger of the mobile device (12) is configured to fully charge the battery of the mobile device (12), further comprising:

a voltmeter configured for connection to the mobile device (12) to determine the fully-charged voltage of the battery,
wherein the computer (20) is configured to determine the available battery capacity based on a difference between the fully-charged voltage and a battery cut off voltage at which the mobile terminal shuts down.

22. The system (10) of any of Claims 13 to 21 wherein the battery simulator (18) is programmed to have an equivalent series resistance (24) equal to the equivalent series resistance of the battery, wherein the equivalent series resistance is used by the battery simulator (18) to generate the simulated battery voltage.

23. A computer-readable medium configured with code to determine standby time for a mobile station (12), the code executable by a computer to cause the computer (20) to carry out the method of any of Claims 1 to 12.

24. The computer-readable medium as claimed in Claim 23 wherein the computer-readable medium is further configured with code that causes the computer (20) to communicate with the mobile station (12) to cause the mobile station to enter the standby mode.

**Patentansprüche**

1. Ein Verfahren zum Bestimmen einer Standby-Zeit für eine mobile Station (12), wobei das Verfahren aufweist:

Erzeugen einer simulierten Batteriespannung für die mobile Station;
Messen eines Stromverbrauchs (102) der mobilen Station (12) in einem Standby-Modus unter Verwendung der simulierten Batteriespannung,
wobei das Messen ein Messen von Stromaktivitäten umfasst, wenn die mobile Station (12) periodisch ihren Empfänger zum Überwachen hinsichtlich eines Kommunikationssignals aktiviert;
Bestimmen einer verfügbaren Batteriekapazität (114) einer Batterie für die mobile Station; und
Bestimmen einer Standby-Zeit (104) für die mobile Station basierend auf dem Stromverbrauch und der verfügbaren Batteriekapazität,
wobei das Messen des Stromverbrauchs für eine Zeitperiode kürzer als die Standby-Zeit der mobilen Station durchgeführt wird.

2. Das Verfahren gemäß Anspruch 1, wobei das Erzeugen der simulierten Batteriespannung durch einen Batteriesimulator (18) durchgeführt wird.

3. Das Verfahren gemäß Anspruch 2, das weiter aufweist:

Programmieren des Batteriesimulators (18) mit einem äquivalenten Serienwiderstand (24) gleich dem äquivalenten Serienwiderstand der Batterie, wobei der äquivalente Serienwiderstand bei einem Erzeugen der simulierten Batteriespannung verwendet wird.

4. Das Verfahren gemäß einem vorhergehenden Anspruch, wobei der gemessene Stromverbrauch ein Mittelwert ist, der über die Zeitperiode bestimmt wird.

5. Das Verfahren gemäß einem vorhergehenden Anspruch, wobei die Zeitperiode eine Stunde ist.

6. Das Verfahren gemäß einem vorhergehenden Anspruch, wobei der Standby-Modus einen Sendemodus und einen Empfangsmodus umfasst.

7. Das Verfahren gemäß Anspruch 6, wobei der Stromverbrauch in sowohl dem Sendemodus als auch dem Empfangsmodus gemessen wird.

8. Das Verfahren gemäß Anspruch 7, wobei das periodische Aktivieren, durch die mobile Station (12), ihres Empfängers, um hinsichtlich eines Kommunikationssignals zu überwachen, in dem Empfangsmodus stattfindet.

9. Das Verfahren gemäß einem vorhergehenden Anspruch, das weiter aufweist: Bestimmen einer Funk-Aus-Batteriespannung (40) für die mobile Station basierend auf der simulierten Batteriespannung.

10. Das Verfahren gemäß Anspruch 9, wobei die Funk-Aus-Batteriespannung (40) für die mobile Station bestimmt wird durch Verringern der simulierten Batteriespannung, bis der Funk der mobilen Station ausgeschaltet wird.

11. Das Verfahren gemäß Anspruch 9 oder Anspruch 10, wobei das Bestimmen einer Funk-Aus-Batteriespannung (40) aufweist:

Vorsehen einer simulierten Batteriespannung mit einem ersten Spannungswert (39) für die mobile Station;
Bestimmen, ob ein Funk der mobilen Station eingeschaltet ist (36);
wenn der Funk der mobilen Station eingeschaltet ist, Dekrementieren des ersten Spannungswerts (38) auf einen nächsten Spannungswert um einen vorgegebenen Betrag, und Wiederholen des Bestimmens, wenn ein Funk der mobilen Station eingeschaltet ist (36); und
wenn der Funk der mobilen Station ausgeschaltet ist, Aufzeichnen des Spannungswerts als die Funk-Aus-Batteriespannung.

12. Das Verfahren gemäß einem der Ansprüche 9 bis 11, das weiter aufweist:

vollständiges Laden der Batterie; und
Bestimmen der "vollständig geladen"-Spannung der Batterie nach dem vollständigen Laden und wobei die verfügbare Batteriekapazität bestimmt wird basierend auf einer Differenz zwischen der "vollständig geladen"-Spannung und der Funk-Aus-Batteriespannung (40).

13. Ein System (10), das konfiguriert ist zum Bestimmen einer Standby-Zeit für eine mobile Station (12), wobei das System aufweist:

einen Batteriesimulator (18), der konfiguriert ist für eine Verbindung mit der mobilen Station (12), wobei der Batteriesimulator (18) konfiguriert ist zum Erzeugen einer simulierten Batteriespannung zur Versorgung der mobilen Station (12) mit Energie; und
einen Computer (20), der konfiguriert ist zum
Messen eines Stromverbrauchs (102) der mobilen Station (12) in einem Standby-Modus, wobei, während der Stromverbrauch gemessen wird, die mobile Station (12) periodisch ihren Empfänger zum Überwachen hinsichtlich eines Kommunikationssignals aktiviert,
Bestimmen einer verfügbaren Batteriekapazität (114) einer Batterie für die mobile Station, und
Bestimmen einer Standby-Zeit (104) für die mobile Station basierend auf dem Stromverbrauch und der verfügbaren Batteriekapazität, wobei das Messen des Stromverbrauchs für eine Zeitperiode kürzer als die Standby-Zeit der mobilen Station durchgeführt wird.

14. Das System (10) gemäß Anspruch 13, das weiter aufweist:

einen Basisstation-Emulator (14), der konfiguriert zum Kommunizieren mit der mobilen Station (12), um die mobile Station (12) zu veranlassen, in den Standby-Modus einzutreten.

15. Das System (10) gemäß Anspruch 13 oder Anspruch 14, wobei der Computer (20) konfiguriert ist zum Messen des Stromverbrauchs als einen Mittelwert, der über die Zeitperiode bestimmt wird.

16. Das System (10) gemäß einem der Ansprüche 13 bis 15, wobei die Zeitperiode eine Stunde ist.

17. Das System (10) gemäß einem der Ansprüche 13 bis 16, wobei der Standby-Modus einen Sendemodus und einen Empfangsmodus umfasst.

18. Das System (10) gemäß Anspruch 17, wobei der Stromverbrauch in sowohl dem Sendemodus als auch dem Empfangsmodus gemessen wird.

**19.** Das System (10) gemäß Anspruch 18, wobei das periodische Aktivieren, durch die mobile Station (12), ihres Empfängers, um hinsichtlich eines Kommunikationssignals zu überwachen, in dem Empfangsmodus stattfindet.

**20.** Das System (10) gemäß einem der Ansprüche 13 bis 19, wobei der Batteriesimulator (18), der Computer (20) und der Basisstation-Emulator (14) konfiguriert sind zum Bestimmen einer Funk-Aus-Batteriespannung (40) durch:

Vorsehen einer simulierten Batteriespannung mit einem ersten Spannungswert für die mobile Station;
Bestimmen, ob ein Funk der mobilen Station eingeschaltet ist;
wenn der Funk der mobilen Station eingeschaltet ist, Dekrementieren des ersten Spannungswerts auf einen nächsten Spannungswert um einen vorgegebenen Betrag, und Wiederholen des Bestimmens, wenn ein Funk der mobilen Station eingeschaltet ist; und
wenn der Funk der mobilen Station ausgeschaltet ist, Aufzeichnen des Spannungswerts als die Funk-Aus-Batteriespannung.

**21.** Das System (10) gemäß einem der Ansprüche 13 bis 20, wobei eine Ladeeinrichtung der mobilen Vorrichtung (12) konfiguriert ist zum vollständigen Laden der Batterie der mobilen Vorrichtung (12), das weiter aufweist:

einen Spannungsmesser, der konfiguriert ist zur Verbindung mit der mobilen Vorrichtung (12), um die "vollständig geladen"-Spannung der Batterie zu bestimmen,
wobei der Computer (20) konfiguriert ist zum Bestimmen der verfügbaren Batteriekapazität basierend auf einer Differenz zwischen der "vollständig geladen"-Spannung und einer Batterie-Aus-Spannung, bei der das mobile GErät ausgeschaltet wird.

**22.** Das System (10) gemäß einem der Ansprüche 13 bis 21, wobei der Batteriesimulator (18) programmiert ist, einen äquivalenten Serienwiderstand (24) gleich dem äquivalenten Serienwiderstand der Batterie zu haben, wobei der äquivalente Serienwiderstand durch den Batteriesimulator (18) verwendet wird, um die simulierte Batteriespannung zu erzeugen.

**23.** Ein computerlesbares Medium, das mit Code konfiguriert ist, um eine Standby-Zeit für eine mobile Station (12) zu bestimmen, wobei der Code durch einen Computer ausführbar ist, um den Computer (20) zu veranlassen, das Verfahren gemäß einem der Ansprüche 1 bis 12 auszuführen.

**24.** Das computerlesbare Medium gemäß Anspruch 23, wobei das computerlesbare Medium weiter mit Code konfiguriert ist, der den Computer (20) veranlasst, mit der mobile Station (12) zu kommunizieren, um die mobile Station zu veranlassen, in den Standby-Modus einzutreten.

**Revendications**

**1.** Procédé de détermination d'un temps d'attente pour une station mobile (12), le procédé comprenant :

la génération d'une tension de batterie simulée pour la station mobile ;
la mesure de la consommation de courant (102) de la station mobile (12) dans un mode d'attente en utilisant la tension de batterie simulée, dans lequel la mesure comprend la mesure des activités actuelles alors que la station mobile (12) active périodiquement son récepteur pour surveiller un signal de communication ;
la détermination d'une capacité de batterie disponible (114) d'une batterie pour la station mobile ; et
la détermination d'un temps d'attente (104) pour la station mobile sur la base de la consommation de courant et de la capacité de batterie disponible,
dans lequel la mesure de la consommation de courant est effectuée pendant une période de temps inférieure au temps d'attente de la station mobile.

**2.** Procédé selon la revendication 1, dans lequel la génération de la tension de batterie simulée est effectuée par un simulateur de batterie (18).

**3.** Procédé selon la revendication 2, comprenant en outre :

la programmation du simulateur de batterie (18) avec une résistance série équivalente (24) égale à la résistance série équivalente de la batterie, dans lequel la résistance série équivalente est utilisée pour la génération de la tension de batterie simulée.

4. Procédé selon l'une quelconque des revendications précédentes, dans lequel la consommation de courant mesurée est une valeur moyenne déterminée pendant la période de temps.

5. Procédé selon l'une quelconque des revendications précédentes, dans lequel la période de temps est une heure.

6. Procédé selon l'une quelconque des revendications précédentes, dans lequel le mode d'attente comprend un mode d'émission et un mode de réception.

7. Procédé selon la revendication 6, dans lequel la consommation de courant est mesurée à la fois dans le mode d'émission et dans le mode de réception.

8. Procédé selon la revendication 7, dans lequel l'activation périodique par la station mobile (12) de son récepteur pour surveiller un signal de communication a lieu dans le mode de réception.

9. Procédé selon l'une quelconque des revendications précédentes comprenant en outre :

la détermination d'une tension de batterie radio coupée (40) pour la station mobile sur la base de la tension de batterie simulée.

10. Procédé selon la revendication 9, dans lequel la tension de batterie radio coupée (40) pour la station mobile est déterminée par une diminution de la tension de batterie simulée jusqu'à ce que la radio de la station mobile soit coupée.

11. Procédé selon la revendication 9 ou la revendication 10, dans lequel la détermination d'une tension de batterie radio coupée (40) comprend :

la fourniture d'une tension de batterie simulée à une première valeur de tension (39) à la station mobile ;
la détermination si une radio de station mobile est active (36) ;
si la radio de station mobile est active, la décrémentation de la première valeur de tension (38) à une valeur de tension suivante d'une quantité prédéterminée, et la répétition de la détermination si une radio de station mobile est active (36) ; et
si la radio de station mobile est coupée, l'enregistrement de la valeur de tension en tant que tension de batterie radio coupée.

12. Procédé selon l'une quelconque des revendications 9 à 11, comprenant en outre :

la charge totale de la batterie ; et
la détermination de la tension de charge totale de la batterie après qu'elle a été totalement chargée, et dans lequel la capacité de batterie disponible est déterminée sur la base d'une différence entre la tension de charge totale et la tension de batterie radio coupée (40).

13. Système (10) configuré pour déterminer un temps d'attente pour une station mobile (12), le système comprenant :

un simulateur de batterie (18) configuré pour une connexion à la station mobile (12), le simulateur de batterie (18) étant configuré pour générer une tension de batterie simulée pour alimenter la station mobile (12) ; et
un ordinateur (20) configuré pour
mesurer la consommation de courant (102) de la station mobile (12) dans un mode d'attente, alors que la consommation de courant est mesurée, la station mobile (12) activant périodiquement son récepteur pour surveiller un signal de communication,
déterminer une capacité de batterie disponible (114) d'une batterie pour la station mobile, et
déterminer un temps d'attente (104) pour la station mobile sur la base de la consommation de courant et de la capacité de batterie disponible, dans lequel la mesure de la consommation de courant est effectuée pendant une période de temps inférieure au temps d'attente de la station mobile.

14. Système (10) selon la revendication 13, comprenant en outre :

un émulateur de station de base (14) configuré pour communiquer avec la station mobile (12) pour amener la station mobile (12) à passer dans le mode d'attente.

**15.** Système (10) selon la revendication 13 ou la revendication 14, dans lequel l'ordinateur (20) est configuré pour mesurer la consommation de courant en tant que valeur moyenne déterminée pendant la période de temps.

**16.** Système (10) selon l'une quelconque des revendications 13 à 15, dans lequel la période de temps est une heure.

**17.** Système (10) selon l'une quelconque des revendications 13 à 16, dans lequel le mode d'attente comprend un mode d'émission et un mode de réception.

**18.** Système (10) selon la revendication 17, dans lequel la consommation de courant est mesurée à la fois dans le mode d'émission et dans le mode de réception.

**19.** Système (10) selon la revendication 18, dans lequel l'activation périodique par la station mobile (12) de son récepteur pour surveiller un signal de communication a lieu dans le mode de réception.

**20.** Système (10) selon l'une quelconque des revendications 13 à 19, dans lequel le simulateur de batterie (18), l'ordinateur (20) et l'émulateur de station de base (14) sont configurés pour déterminer une tension de batterie radio coupée (40) en :

fournissant une tension de batterie simulée à une première valeur de tension à la station mobile ;
déterminant si une radio de station mobile est active ;
si la radio de station mobile est active, décrémentant la première valeur de tension à une valeur de tension suivante d'une quantité prédéterminée, et répétant la détermination si une radio de station mobile est active ; et
si la radio de station mobile est coupée, enregistrant la valeur de tension en tant que tension de batterie radio coupée.

**21.** Système (10) selon l'une quelconque des revendications 13 à 20, dans lequel un chargeur du dispositif mobile (12) est configuré pour charger totalement la batterie du dispositif mobile (12), comprenant en outre :

un voltmètre configuré pour une connexion au dispositif mobile (12) pour déterminer la tension de charge totale de la batterie,
dans lequel l'ordinateur (20) est configuré pour déterminer la capacité de batterie disponible sur la base d'une différence entre la tension de charge totale et une tension de coupure de batterie à laquelle le terminal mobile est arrêté.

**22.** Système (10) selon l'une quelconque des revendications 13 à 21, dans lequel le simulateur de batterie (18) est programmé pour avoir une résistance série équivalente (24) égale à la résistance série équivalente de la batterie, dans lequel la résistance série équivalente est utilisée par le simulateur de batterie (18) pour générer la tension de batterie simulée.

**23.** Support pouvant être lu par un ordinateur configuré avec un code pour déterminer un temps d'attente pour une station mobile (12), le code pouvant être exécuté par un ordinateur pour amener l'ordinateur (20) à mettre en oeuvre le procédé selon l'une quelconque des revendications 1 à 12.

**24.** Support pouvant être lu par un ordinateur selon la revendication 23, dans lequel le support pouvant être lu par un ordinateur est en outre configuré avec un code qui amène l'ordinateur (20) à communiquer avec la station mobile (12) pour amener la station mobile à passer dans le mode d'attente.

**Fig. 1**

**Fig. 2**

Fig. 3

Current (A)

sample interval Δt

Data Points

beginning of sub array k=0

end of sub-array k=m

Fig. 4

100

| Determine available capacity of battery | Measure average current consumption |
|---|---|

114                    102

| Calculate the standby time of the MSUT |
|---|

104

Fig. 5

110

| Determine the battery shut off voltage |
|---|

112

| Determine available capacity of battery | Measure average current consumption |
|---|---|

114                    102

| Calculate the standby time of the MSUT |
|---|

104

Fig. 6

EP 2 270 527 B1

Fig. 7

Fig. 8

130

- Determine the battery shut off voltage — 112
- Determine the available capacity of the battery — 114
- Measure transmit current — 122
- Measure receive current — 124
- Calculate the standby time of the MSUT — 104

$V_{cutoff}$, $C_{new} - C_{cutoff}$, $C_{tx\_in\_1hr}$, $C_{rx\_in\_1hr}$, $t_{tx\_in\_1hr}$

102

**Fig. 9**

30

34 Wait for Battery Voltage Update

36 Radio ON?

NO → 40 Record Voltage Level → 42 Turn Radio Back On, Go to Step 34 N times, Otherwise end

YES → 38 Decrement Battery Voltage

32
33 Set ESR → 35 Set base station emulator → 37 Wait for MSUT to enter slotted mode → 39 Set initial value of battery simulator

**Fig. 10**

Fig. 11

123

| Repeat N times |
| --- |

Trigger the simulator to start collecting current measurement data points when a transmit activity is detected

201

Collect a sufficient time span of current measurement data points

202

Extract the measurements relating to the time the transmitter is turned on

204

| Next iteration |
| --- |

Calculate the capacity used ($C_j$) and time duration ($t_j$) of each transmit event,

207

Determine the average capacity used by transmit events in one hour and the time spent in transmitting events during one hour

208

Fig. 12

Configuring the base station emulator to disable timer based registration and all other types registrations except the power up registration

222

Measure the receive current array of the MSUT segment by segment using a sampling interval small enough to capture all current activities

224

Fig. 13

125

Configuring the base station emulator to disable timer based registration and all other types registrations except the power up registration

222

Measure the receive current array of the MSUT segment by segment using a sampling interval small enough to capture all current activities

224

Record multiple receive current segments

226

For each segment

Post process the current measurement data array

228

Calculate the mean current value of each receive segment

230

Next segment

Calculate the mean over all the segments measured

232

Determine the capacity used while in receive mode for 1 hour of MSUT operation

234

Fig. 14